# EUROPEAN PATENT APPLICATION

(11) **EP 2 372 918 A1**
(43) Date of publication of application: **05.10.2011**
(21) Application number: 11158234.2
(22) Date of filing: 15.03.2011
(51) Int. Cl.: H03M 7/30

(54) **Compression dictionary synchronization method and device**

(30) Priority: 15.03.2010 CN 201010127111
(71) Applicant: Huawei Technologies Co., Ltd., Longgang District, Shenzhen Guangdong 518129 (CN)
(72) Inventor: Hunag, Zhigang, Shenzhen Guangdong 518129 (CN); Li, Chunqiang, Shenzen Guangdong 518129 (CN); Li, Feng, Shenzhen Guangdong 518129 (CN)
(74) Representative: Charles, Glyndwr

(57) **Abstract**

A compression dictionary synchronization method and device are provided. The method includes: obtaining a synchronization information field of a dictionary entry in a compression dictionary corresponding to data to be sent; judging, according to the synchronization information field, whether a network device at a receiving side has the dictionary entry; and synchronizing the dictionary entry with the network device at the receiving side if the network device at the receiving side does not have the dictionary entry, so that after receiving the data which is to be sent and is compressed by data redundancy elimination according to the dictionary entry, the network device at the receiving side can decompress the compressed data to be sent according to the dictionary entry. Data redundancy is decreased by reducing useless dictionary entry synchronization between devices.

## Description

### FIELD OF THE INVENTION

The present invention relates to a data compression technology, and in particular, to a compression dictionary synchronization method and device.

### BACKGROUND OF THE INVENTION

The data compression technology is widely applied, and can be used to compress files of words, images, audios, and videos of any format. Compression processing can be performed not only on a personal computer, a server, or any special device, but also on a network device (such as a router, or a switch). A typical application scenario is data transmission between different network devices of an enterprise. During data transmission, since a lot of data redundancy exists, a network device at a sending side first compresses data, and then a network device at a receiving side performs decompression, thus effectively decreasing the data transmission volume on the network, fully utilizing the network bandwidth, and reducing the transmission delay.

Two kinds of data compression technologies are usually used in a network device: one is a Lempel-Ziv (LZ) compression technology, and the other is a data redundancy elimination technology. In the LZ compression technology, an LZ compression algorithm or an extensive algorithm of the LZ compression algorithm is usually used. Usually, a sliding window is used to perform longest match in a data block to generate a compression dictionary for compression; a receiving side automatically generates a corresponding compression dictionary according to the algorithm, and performs decompression; and usually, a compression ratio about 40% is achieved. A principle of the data redundancy elimination technology is based on repeatability of large data blocks during data transmission. The network device saves large data blocks passing by, and records corresponding contents in a dictionary. If a repeated data block is found, replacement is performed by using an index in the dictionary. A compression ratio greater than 50:1 is usually achieved, but dictionary entries require to be synchronized.

In the data redundancy elimination technology, same entries exist in both the dictionary at the sending side and the dictionary at the receiving side. When transmitting data, a network device at a sending side segments data to be transmitted, replaces the data, obtained after segmenting, with indexes in the dictionary according to the dictionary entries, and then sends the data. A network device at a receiving side performs decompression according to the dictionary entries, recovers an original data stream, and sends the recovered data stream to a destination. Both the above data compression and decompression need a compression dictionary. The dictionary entries are usually generated by the network device at the sending side, and are synchronized to the device at the receiving side. If the receiving side does not have the corresponding dictionary entries, the decompression cannot be performed, and the original data cannot be recovered. The synchronization of the dictionaries can be performed by interaction between the devices according to a pre-defined protocol. When the receiving side cannot perform decompression because the dictionary entries cannot be found, the receiving side may send a request to the network device at the sending side, and request the network device at the sending side to re-perform the synchronization of the dictionary entries, which is called passive synchronization, and is mainly applied in abnormal cases (for example, the synchronization of the dictionaries fails, or the dictionary entries at one side are replaced). Since in this manner, data delay of the current transmission is increased, and the decompression can be performed only after the dictionary entries are synchronized.

During the implementation of the present invention, the inventors find that the prior art has at least the following problems. When the above data compression is only performed between two network devices, since the synchronization of dictionaries are only required to be performed between the two network devices, the process is simple. However, when the quantity of the network devices in an enterprise is large, the synchronization of the dictionaries requires to be performed among a large quantity of network devices, thus greatly increasing the complexity. According to a conventional technical solution, each network device maintains compression dictionaries for each of other network devices. The problem is that storage space is wasted, and redundancy of data traffic between different network devices in an enterprise is high. According to another conventional technical solution, another dictionary synchronization method exists. According to this method, a uniform dictionary mode is used, and a global dictionary synchronization mechanism is adopted. However, in the method, the synchronization is aimless, because a device does not know in advance whether synchronized dictionary entries are to be used subsequently. When no similar data is transmitted, the dictionary entries are useless, and are aged due to timeout or be replaced with other entries due to limited space. In addition, the dictionary entries include indexes, time to live, and corresponding data segments. The synchronization is performed between all of the network devices, which occupies a large amount of memory and disk space of the device. When the quantity of the network devices is large, data transmission volume in the network is seriously increased. In view of the above, the prior art still cannot reduce the synchronization of the dictionary entries between the devices to reduce the data redundancy.

### SUMMARY OF THE INVENTION

The present invention is directed to a compression dictionary synchronization method and device, so as to decrease data redundancy by reducing dictionary entry synchronization between devices.

An embodiment of the present invention provides a compression dictionary synchronization method, where the method includes:
obtaining a synchronization information field of a dictionary entry in a compression dictionary corresponding to data to be sent;
judging, according to the synchronization information field, whether a network device at a receiving side has the dictionary entry; and
synchronizing the dictionary entry with the network device at the receiving side if the network device at the receiving side does not have the dictionary entry, so that after receiving the data which is to be sent and is compressed by data redundancy elimination according to the dictionary entry, the network device at the receiving side can decompress the compressed data to be sent according to the dictionary entry.

An embodiment of the present invention provides a compression dictionary synchronization device, where the method includes:
an obtaining unit, configured to obtain a synchronization information field of a dictionary entry in a compression dictionary corresponding to data to be sent;
a judging unit, configured to judge, according to the synchronization information field, whether a network device at a receiving side has the dictionary entry; and
a synchronization unit, configured to synchronize the dictionary entry with the network device at the receiving side if the network device at the receiving side does not have the dictionary entry, so that after receiving the data which is to be sent and is compressed by data redundancy elimination according to the dictionary entry, the network device at the receiving side can decompress, according to the dictionary entry, the compressed data to be sent.

Beneficial effects of the above technical solutions are as follows. Since a field is added in a dictionary entry to record whether each peer network device has the dictionary entry, when transmitting data, a device can judge whether the peer network device has the dictionary entry according to the field. If the peer network device does not have the dictionary entry, according to the technical solution, a synchronization process is performed on the entry first, thus decreasing data redundancy by reducing dictionary entry synchronization between devices, and saving storage space of the network device.

### BRIEF DESCRIPTION OF THE DRAWINGS

To illustrate the technical solutions according to the embodiments of the present invention or in the prior art more clearly, the accompanying drawings for describing the embodiments or the prior art are introduced briefly in the following. Apparently, the accompanying drawings in the following description are only some embodiments of the present invention, and persons of ordinary skill in the art can derive other drawings from the accompanying drawings without creative efforts.
FIG. 1 is a schematic view of contents of dictionary entries according to an embodiment of the present invention;
FIG. 2 is a schematic structural view of a synchronization information field according to an embodiment of the present invention;
FIG. 3 is a schematic view of parameter information of a peer network device according to an embodiment of the present invention;
FIG. 4 is a flow chart of a compression dictionary synchronization method according to an embodiment of the present invention;
FIG. 5 is a schematic structural view of a network in a specific example according to an embodiment of the present invention; and
FIG. 6 is a schematic structural view of a compression dictionary synchronization device according to an embodiment of the present invention.

### DETAILED DESCRIPTION OF THE EMBODIMENTS

The technical solution of the present invention will be clearly described in the following with reference to the accompanying drawings. It is obvious that the embodiments to be described are only a part rather than all of the embodiments of the present invention. All other embodiments obtained by persons skilled in the art based on the embodiments of the present invention without creative efforts shall fall within the protection scope of the present invention.

In an embodiment of the present invention, a method for synchronizing compression dictionaries between network devices is provided, which can add a field into a dictionary entry to record whether the dictionary entry exists in each peer network device, so that when transmitting data, a device can judge, according to the field, whether a peer network device has the dictionary entry. If the peer network device does not have the dictionary entry, synchronization of the entry is performed first.

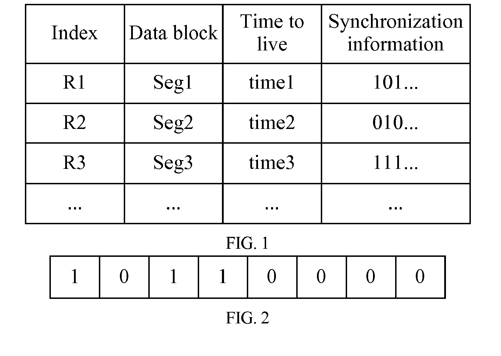

FIG. 1 is a schematic view of contents of dictionary entries according to the embodiment of the present invention. The dictionary entry at least includes indexes, data block contents, and synchronization information. A synchronization information field may be a bit string of any number of bits. Each bit in the bit string corresponds to one peer network device. FIG. 2 is a schematic structural view of the synchronization information field according to an embodiment of the present invention. For one bit (for example, a first, third, or fourth bit from the left) in the synchronization information field, if the bit is 1, it means that corresponding network device has the dictionary entry; and if the bit is 0, it means that the corresponding network device does not have the dictionary entry. It should be understood by persons of ordinary skill in the art that, 0 may also be used to represent that the corresponding network device has the dictionary entry, and 1 represents that the corresponding network device does not have the dictionary entry.

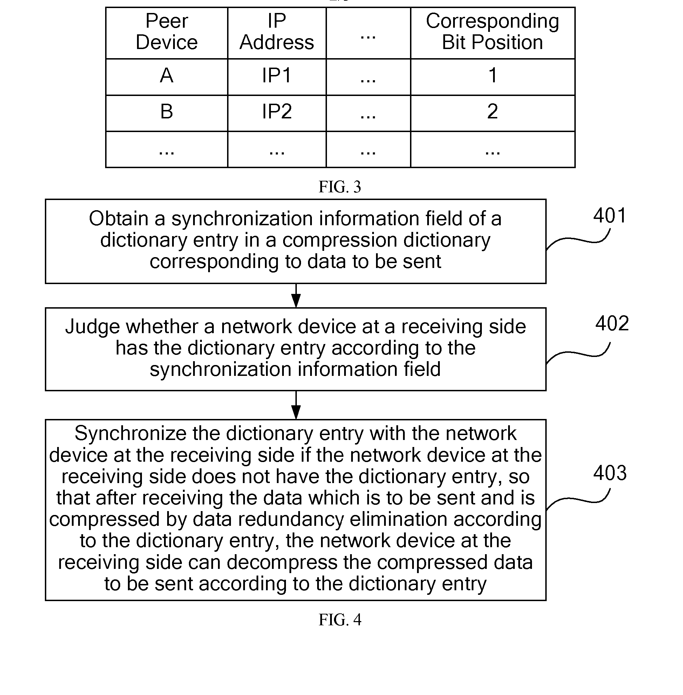

When a network device is started up, the network device initiates a network device discovery process to determine the peer network device and negotiate on some parameters. After the network device discovery process, each network device determines the peer network devices, and saves IP addresses of the peer network devices and negotiated parameters (FIG. 3 is a schematic view of parameter information of the peer network devices according to an embodiment of the present invention), which are used in subsequent data transmission. Alternatively, the IP address may be replaced by an identity of the network device. In maintenance information of each device, a corresponding bit position represents which bit of the synchronization information field is to be used to record whether the network device has a corresponding dictionary entry. For ease of programming, a corresponding bit may also be represented in the form of a mask. For example, 00000100 represents that the device corresponds to the third bit from the right in the synchronization information field. During judging, an AND operation is performed on 00000100 and the synchronization information field, if a result is greater than 1, it indicates that the corresponding network device has the dictionary entry; otherwise, it indicates that the corresponding network device does not have the dictionary entry. It should be understood by persons skilled in the art that, if 0 is used to represent that the corresponding network device has the dictionary entry, an OR operation is performed on the mask and the synchronization information field. If each bit in a result is 1, it indicates that the corresponding network device does not have the dictionary entry. For ease of subsequent dictionary synchronization, the device information may be sequenced according to a rule (for example, according to an IP address sequence of the devices), so that the bit positions corresponding to each of the devices is in the same sequence as that of the devices, and a bit corresponding to a network device is easy to be found to determine whether a corresponding dictionary entry exists. When a network device detects that peer network device is re-started up, if this device has dictionary entries, bits in the synchronization information field of all dictionary entries corresponding to the peer network device are reset as 0 to represent that the peer network device does not have the dictionary entries.

FIG. 4 is a flow chart of a compression dictionary synchronization method according to an embodiment of the present invention, the method is applied during data compression and transmission performed by a network device at a sending side and a network device at a receiving side, and the method includes the following steps.

In step 401, a synchronization information field of a dictionary entry in a compression dictionary corresponding to data to be sent is obtained.

Optionally, the above step may include: segmenting, by the network device at the sending side, the data to be sent, and searching the compression dictionary for a dictionary entry corresponding to each segment.

If the dictionary entry corresponding to one or more of the segments is not found by the network device at the sending side in the compression dictionary, the network device at the sending side generates one new dictionary entry for one segment, or generates more than one dictionary entry for more than one segment. Then, the network device at the sending side and the above network device at the receiving side perform synchronization in terms of the new dictionary entry, and modify the synchronization information field in the new dictionary entry. For example, a corresponding bit of the synchronization information field is modified to represent information that the network device at the receiving side has synchronized the new dictionary entry. Then, the procedure may proceed to steps after steps 402 and 403 (because the step of synchronizing new dictionary entry and the step of modifying the synchronization information field are equivalent to steps 402 and 403), or may proceed to step 402. Alternatively, after the new dictionary entry is established, all bits of the synchronization information of the new dictionary entry may be set to represent information that network devices corresponding to the bits have not synchronized the dictionary entry, and the procedure proceeds to step 402.

If a dictionary entry corresponding to one segment is found by the network device at the sending side in the compression dictionary or multiple dictionary entries corresponding to multiple segments are found by the network device at the sending side in the compression dictionary, the network device at the sending side obtains the synchronization information field of the corresponding dictionary entry or the synchronization information fields of the corresponding dictionary entries.

In step 402, whether the network device at the receiving side has the dictionary entry is judged according to the synchronization information field.

Optionally, the synchronization information field may be a bit string. A bit in the bit string may be used to correspond to the network device at the receiving side to represent the information whether the network device at the receiving side has synchronized the dictionary entry.

In step 403, if the network device at the receiving side does not have the above dictionary entry, the network device at the sending side synchronizes the dictionary entry with the network device at the receiving side, so that after receiving the data which is to be sent and is compressed by data redundancy elimination according to the dictionary entry, the network device at the receiving side can decompress the compressed data to be sent according to the dictionary entry.

Optionally, the network device at the sending side may synchronize the dictionary entry with the network device at the receiving side by message interaction or by carrying the dictionary entry in the transmitted data. If it is judged, according to the synchronization information field, that the network device at the receiving side does not have the above dictionary entry, the network device at the sending side may initiatively synchronize the above dictionary entry before, during, or after the compressed data is sent with the network device at the receiving side, by sending a message to the network device at the receiving side, so that by the message interaction, the network device at the sending side synchronizes the dictionary entry with the network device at the receiving side. The network device at the sending side may also synchronize the dictionary entry with the network device at the receiving side by carrying the dictionary entry the network device at the receiving side does not have in the transmitted data. That is to say, after the data to be sent is compressed, a packet carrying the compressed data carries the dictionary entry to be synchronized. After receiving the compressed data sent by the network device at the sending side, the network device at the receiving side adds the carried dictionary entry to the compression dictionary, that is, synchronizes the dictionary entry, and decompresses the corresponding compressed segments according to the synchronized dictionary.

If the network device at the receiving side has the above dictionary entry, the synchronization of the dictionary entry is not required, the data can be directly sent to the network device at the receiving side, and the network device at the receiving side performs the decompression according to existing dictionary entry thereof.

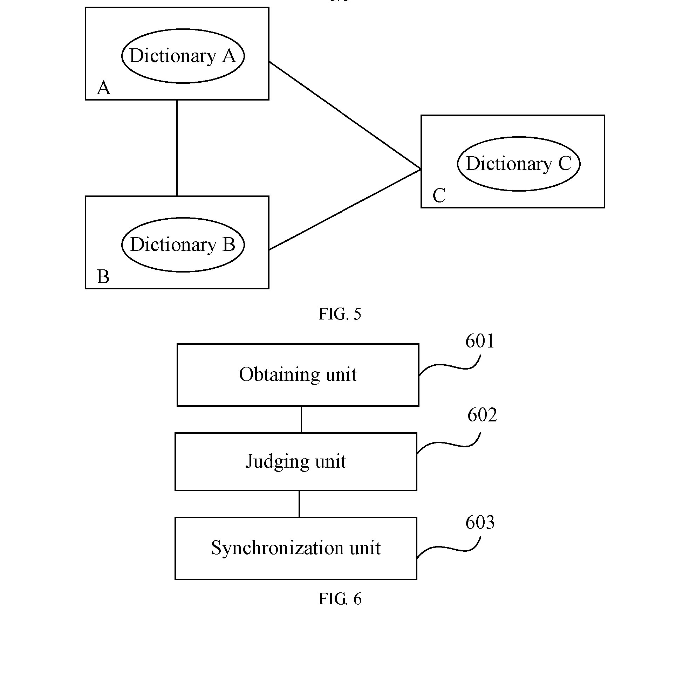

The dictionary synchronization method according to the embodiment of the present invention is described below by taking a network structure shown in FIG. 5 for example. Network devices A, B, and C are egress routers of an enterprise, are located in different cities, and transmit data through a Wide Area Network (WAN). Assuming that data is transmitted between the C and the A. The C segments the data to be transmitted, and searches a compression dictionary for a corresponding dictionary entry segment by segment. Taking one of the segments for example, if the segment does not have a corresponding dictionary entry, the C establishes a dictionary entry for the segment, allocates an index value, sets corresponding time to live, and synchronizes with A in terms of the contents of the dictionary entry, so that the A can perform decompression upon receiving the data. The C sets a bit position in a synchronization information field of the dictionary entry corresponding to the A as 1 to represent that the device A already has the dictionary entry. Finally, the data is compressed, and indexes are used to replace data blocks. If the segment has the corresponding dictionary entry in the C, the C judges, according to the bit position in the synchronization information field corresponding to the A, whether the A has the entry. If yes, the C performs the compression directly; if not, the C is required to synchronize with A in terms of the dictionary entry, modifies the bit position, corresponding to the A, to 1, in the synchronization information field of the dictionary entry, and then performs the data compression.

Since storage space of the device is limited, an aging mechanism may be used to delete a dictionary entry: when a dictionary entry is not used for longer than certain duration, the entry is deleted, and this is a first case in which the dictionary entry is deleted. In another case, the dictionary entry is deleted due to limited storage space. Because no space is available for storing a new entry, the old dictionary entry has to be deleted. When the dictionary entry is deleted, the network device, whose corresponding bit in its synchronization information field is 1, is required to be informed. The network device of this side informs the peer network device that the dictionary entry is already deleted, and the peer network device updates the corresponding bit in the dictionary entry, so as to keep the two sides consistent. The deletion of the dictionary entry may occur frequently, thus resulting in many corresponding synchronization messages. A batch updating method may be used, so that multiple dictionary entries are synchronized during one synchronization process to reduce the number of the messages.

According to the embodiment of the present invention, an individual device uses the same compression dictionary, and the synchronization is performed only when a relevant dictionary entry is to be used, thus reducing data redundancy. During compressing, the network device at the sending side knows whether the network device at the receiving side has a corresponding dictionary entry, and transmits the dictionary entry by using a data packet carrying the dictionary entry if the network device at the receiving side does not have the corresponding dictionary entry, thus solving the problem of time delay of passive dictionary synchronization. Dictionary synchronization is not required to be performed on the network device in a global manner, thus reducing data for the dictionary synchronization between the devices, decreasing the storage space, and saving the network bandwidth.

Accordingly, FIG. 6 is a schematic structural view of a compression dictionary synchronization device according to an embodiment of the present invention, and the device includes:
an obtaining unit 601, configured to obtain a synchronization information field of a dictionary entry in a compression dictionary corresponding to data to be sent;
a judging unit 602, configured to judge, according to the synchronization information field, whether the network device at a receiving side has the dictionary entry; and
a synchronization unit 603, configured to synchronize the dictionary entry with the network device at the receiving side, if the network device at the receiving side does not have the above dictionary entry, so that after receiving the data which is to be sent and is compressed by data redundancy elimination according to the dictionary entry, the network device at the receiving side can decompress, according to the dictionary entry, the compressed data to be sent.

Optionally, the obtaining unit 601 is further configured to segment the data to be sent, search the compression dictionary for a dictionary entry corresponding to each segment, and obtain the synchronization information field of a corresponding dictionary entry if the corresponding dictionary entry is found in the compression dictionary. The obtaining unit 601 is further configured to establish a new dictionary entry for the segmented data to be sent if the corresponding dictionary entry is not found in the compression dictionary, synchronize the new dictionary entry with the network device at the receiving side, and modify the synchronization information field of the new dictionary entry in the compression dictionary to include information that the network device at the receiving side has synchronized the dictionary entry. The above synchronization information field may be a bit string, and a bit in the bit string may be used to correspond to the network device at the receiving side to represent the information of whether the network device at the receiving side has synchronized the dictionary entry. The judging unit 602 is further configured to judge, according to the bit in the synchronization information field corresponding to the network device at the receiving side, whether the network device at the receiving side has the dictionary entry. The obtaining unit 601 may further be configured to modify the bit in the synchronization information field of the new dictionary entry in the compression dictionary corresponding to the network device at the receiving side to include the information that the network device at the receiving side has synchronized the dictionary entry.

Optionally, the synchronization unit 603 may further be configured to synchronize the dictionary entry with the network device at the receiving side by message interaction or by carrying the dictionary entry in the transmitted data. The dictionary synchronization may be performed by special message interaction. The dictionary synchronization may also be performed by the compressed data carrying the dictionary entry and by using a pre-defined packet format. Thus, the network device at the peer can directly extract information from the compressed data, and generate the corresponding dictionary entry. During the synchronization, information (such as an index, a data block, time to live, synchronization information) of the whole dictionary entry may be sent to the peer network device, so as to keep the information of the dictionary entries at the two sides consistent.

According to the embodiment of the present invention, an individual device uses the same compression dictionary, and the synchronization is performed only when a relevant dictionary entry is to be used, thus reducing data redundancy. During compressing, the network device at the sending side knows whether the network device at the receiving side has a corresponding dictionary entry, and transmits the dictionary entry by using a data packet carrying the dictionary entry if the network device at the receiving side does not have the corresponding dictionary entry, thus solve the problem of time delay of passive dictionary synchronization. Dictionary synchronization is not required to be performed on the network device in a global manner, thus decreasing data for the dictionary synchronization between the devices, decreasing the storage space, and saving the network bandwidth.

Those of ordinary skill in the art should understand that all or a part of the steps of the method according to the embodiments of the present invention may be implemented by a program instructing relevant hardware. The program may be stored in a computer readable storage medium. When the program is run, the steps of the method according to the embodiments of the present invention are performed. The storage medium may be a ROM, a RAM, a magnetic disk, and an optical disk.

The objectives, technical solutions, and beneficial effects of the present invention have been described in further detail through the above specific embodiments. It should be understood that the above descriptions are merely specific embodiments of the present invention, but not intended to limit the present invention. Any modification, equivalent replacement, or improvement made without departing from the principle of the present invention should fall within the scope of the present invention.

## Claims

1. A compression dictionary synchronization method, comprising:
obtaining (401) a synchronization information field of a dictionary entry in a compression dictionary corresponding to data to be sent;
judging (402), according to the synchronization information field, whether a network device at a receiving side has the dictionary entry; and
synchronizing (403) the dictionary entry with the network device at the receiving side if the network device at the receiving side does not have the dictionary entry, so that after receiving the data which is to be sent and is compressed by data redundancy elimination according to the dictionary entry, the network device at the receiving side decompresses the compressed data to be sent according to the dictionary entry.

2. The method according to claim 1, wherein the obtaining (401) the synchronization information field of the dictionary entry in the compression dictionary corresponding to the data to be sent comprises:
segmenting the data to be sent, and searching the compression dictionary for a dictionary entry corresponding to each segment; and
obtaining the synchronization information field of a corresponding dictionary entry if the corresponding dictionary entry is found in the compression dictionary.

3. The method according to claim 2, wherein the obtaining (401) the synchronization information field of the dictionary entry in the compression dictionary corresponding to the data to be sent further comprises:
establishing a new dictionary entry for the segmented data to be sent if the corresponding dictionary entry is not found in the compression dictionary; synchronizing the new dictionary entry with the network device at the receiving side; and modifying the synchronization information field of the new dictionary entry in the compression dictionary to comprise information that the network device at the receiving side has synchronized the dictionary entry.

4. The method according to any one of the claims 1 to 3, wherein the synchronization information field is a bit string, a bit in the bit string is used to correspond to the network device at the receiving side to represent the information whether the network device at the receiving side has synchronized the dictionary entry; and
the judging whether the network device at the receiving side has the dictionary entry according to the synchronization information field comprises:
judging, according to the bit in the synchronization information field corresponding to the network device at the receiving side, whether the network device at the receiving side has the dictionary entry.

5. The method according to claim 3, wherein the synchronization information field is a bit string, a bit in the bit string is used to correspond to the network device at the receiving side to represent the information whether the network device at the receiving side has synchronized the dictionary entry; and
the modifying the synchronization information field of the new dictionary entry in the compression dictionary to comprise the information that the network device at the receiving side has synchronized the dictionary entry comprises:
modifying the bit in the synchronization information field of the new dictionary entry in the compression dictionary corresponding to the network device at the receiving side to comprise the information that the network device at the receiving side has synchronized the dictionary entry.

6. The method according to any one of the claims 1 to 5, wherein the synchronizing the dictionary entry with the network device at the receiving side comprises:
synchronizing the dictionary entry with the network device at the receiving side by message interaction or by carrying the dictionary entry in the transmitted data.

7. A compression dictionary synchronization device, comprising:
an obtaining unit, configured to obtain (401) a synchronization information field of a dictionary entry in a compression dictionary corresponding to data to be sent;
a judging unit, configured to judge (402), according to the synchronization information field, whether a network device at a receiving side has the dictionary entry; and
a synchronization unit, configured to synchronize (403) the dictionary entry with the network device at the receiving side if the network device at the receiving side does not have the above dictionary entry, so that after receiving the data which is to be sent and is compressed by data redundancy elimination according to the dictionary entry, the network device at the receiving side decompresses the compressed data to be sent according to the dictionary entry.

8. The device according to claim 7, wherein the obtaining unit is further configured to segment the data to be sent, search the compression dictionary for a dictionary entry corresponding to each segment, and obtain the synchronization information field of a corresponding dictionary entry if the corresponding dictionary entry is found in the compression dictionary.

9. The device according to claim 8, wherein the obtaining unit is further configured to establish a new dictionary entry for the segmented data to be sent if the corresponding dictionary entry is not found in the compression dictionary, synchronize the new dictionary entry with the network device at the receiving side, and modify the synchronization information field of the new dictionary entry in the compression dictionary to comprise information that the network device at the receiving side has synchronized the dictionary entry.

10. The device according to any one of the claims 7 to 9, wherein the synchronization information field is a bit string, a bit in the bit string is used to correspond to the network device at the receiving side to represent the information whether the network device at the receiving side has synchronized the dictionary entry; and
the judging unit is further configured to judge, according to the bit in the synchronization information field corresponding to the network device at the receiving side, whether the network device at the receiving side has the dictionary entry.

11. The device according to claim 9, wherein the synchronization information field is a bit string, a bit in the bit string is used to correspond to the network device at the receiving side to represent the information whether the network device at the receiving side has synchronized the dictionary entry; and
the obtaining unit is further configured to modify the bit in the synchronization information field of the new dictionary entry in the compression dictionary corresponding to the network device at the receiving side to comprise the information that the network device at the receiving side has synchronized the dictionary entry.

12. The device according to any one of the claims 7 to 11, wherein the synchronization unit is further configured to synchronize the dictionary entry with the network device at the receiving side by message interaction or by carrying the dictionary entry in the transmitted data.
